# EUROPEAN PATENT APPLICATION

(11) **EP 4 571 834 A2**
(43) Date of publication of application: **18.06.2025**
(21) Application number: 24218717.7
(22) Date of filing: 10.12.2024
(51) Int. Cl.: H01L 25/065, H01L 23/00, H01L 25/18

(54) **A SYSTEM AND METHOD FOR FLEXIBLE EXTENSION OF CONNECTIVITY WITHIN AN INTEGRATED CIRCUIT SYSTEM IN A PACKAGE**

(30) Priority: 11.12.2023 US 202363608663 P; 26.04.2024 US 202418647840
(71) Applicant: Avago Technologies International Sales Pte. Limited, Singapore 768923 (SG)
(72) Inventor: Tufano, Andrew Joseph, Irvine, 92618 (US); Zhou, Ting, Irvine, 92618 (US); Paulson, Christopher Dale, Irvine, 92618 (US)
(74) Representative: Dilg, Haeusler, Schindelmann Patentanwaltsgesellschaft mbH

(57) **Abstract**

An integrated circuit package (100) includes a first integrated circuit die (104), a second integrated circuit die (106), and a third integrated circuit die (110). The integrated circuit package (100) also includes a support structure (120, 130). The first die, the second die, and the third die are attached to the support structure (120, 130). The first integrated circuit die (104) includes a first interface on a first side of the first integrated circuit die (104) and the second integrated circuit die (106) includes a second interface on a second side of the second integrated circuit die (106). The first side neighbors the second side. The first integrated circuit die (104) is configured to communicate with second integrated circuit die (106) via the first interface and the second interface. The first integrated circuit die (104) includes a third interface on a third side of the first integrated circuit die (104) and the second integrated circuit die (106) includes a fourth interface on a fourth side of the second integrated circuit die (106). The third die includes a fifth interface on a fifth side and a sixth interface on sixth side. The sixth side is parallel to the third side and the fifth side, The first integrated circuit die (104) is configured to communicate with the third integrated circuit die (110) via the fifth interface and the third interface. The second integrated circuit die (106) is configured to communicate with the third integrated circuit die (110) via the sixth interface and the fourth interface.

## Description

### Cross Reference to Related Patent Application

This application claims the benefit of and the priority to U.S. Provisional Patent Application No. 63/608,663, filed December 11, 2023, the entire disclosure of which is incorporated by reference herein.

### Technical Field

The present disclosure generally relates to the field of electronic assemblies for a number of integrated circuit (IC) die. IC die can be provided on or within a module or integrated circuit (IC) package.

### Background

An IC package can be a multi-chip module (MCM). Each of the IC die in an MCM is generally connected by fine wires or by solder bumps to an interposer or package substrate. The interposer can be attached to a package substrate. Interposers and package substrates are often manufactured from a material such as silicon or other semiconductor or insulative materials. The term integrated circuit multi-chip module can refer to a package including two or more IC dies. An MCM can be or include a system in a package (SIP).

### Brief Description of the Drawing

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.
FIG. 1 is schematic cross sectional view drawing of an electronic package with a number of semiconductor chips or IC die according to some.
FIG. 2 is schematic top planar view drawing of the electronic package illustrated in FIG. 1 according to some embodiments.
FIG. 3 is general block diagram of an HBM IC die for the electronic package illustrated in FIG. 1 according to some embodiments.
FIG. 4 is general block diagram of an HBM IC die for the electronic package illustrated in FIG. 1 according to some embodiments.
FIG. 5 is schematic top planar view drawing of an electronic package with a number of semiconductor chips or IC die according to some embodiments.
FIG. 6 is schematic top planar view drawing of an electronic package with a number of semiconductor chips or IC die according to some embodiments.

### Detailed Description

The illustrations in the drawings are schematic. It is noted that in different figures, similar or identical elements or features are provided with the same reference signs or with reference signs, which are different from the corresponding reference signs only within the first digit. In order to avoid unnecessary repetitions, elements or features, which have already been elucidated with respect to a previously described embodiment, are not elucidated again at a later position of the description.

Further, spatially relative terms, such as "vertical", "horizontal", "bottom", "top", ""front" and "back", "above" and "below", "left" and "right", et cetera are used to describe an element's relationship to another element(s) as illustrated in the Figures. Thus, the spatially relative terms may apply to orientations in use which differ from the orientation depicted in the Figures. All such spatially relative terms refer to the orientation shown in the Figures only for ease of description and are not necessarily limiting as an apparatus according to some embodiments can assume orientations different than those illustrated in the Figures when in use.

Systems and methods can be used with a system in a package (SIP). A system can refer to an integrated circuit package containing an integrated system of some or all components of a computer, communication system, processing system, sensor system, storage system, or other electronic system in some embodiments. These components can include one or more on-chip central processing units (CPUs), memories, radios, network circuits, memory interfaces, input/output devices and interfaces, and secondary storage interfaces, often alongside other components such as radio modems and graphics processing units (GPUs) in some embodiments. SIPs may contain digital and/or analog, mixed-signal and often radio frequency signal processing functions or may contain a discrete application processor in some embodiments. The components of the SIP can be provided on two or more IC die.

The systems and methods described herein can be used with processors or application specific circuits (ASIC's) that make use of 2 dimensional (2D), 2.5D and 3D techniques to integrate a number (e.g., a multitude) of individual die within a system in package (SIP) to optimize the various device functions to the best suited manufacturing processes. In some embodiments, a SIP includes
components used in high performance computing (HPC) systems including but not limited to high bandwidth memory (HBM). The HBM is provided as a 3D stack of DRAM die connected using through silicon vias (TSV's) to a bottom die (e.g., a buffer die). The bottom die provides high speed Input/Output (I/O) connections to an adjacent die in some embodiments. The connections can be routed between the dies using an interposer configured for high density signal routing in some embodiments. From a connectivity standpoint, conventional die to die (D2D) connections provided over the interposer are a single termination point (e.g., an additional way to make additional connections to the HBM device from alternate signal paths is difficult or impossible to practically achieve) system. In some embodiments, the systems and methods overcome disadvantages associated with an HBM created connectivity wall that can prevent additional scale-out in connectivity due to adjacent die sitting on the interposer. In some embodiments, the systems and methods take advantage of the ability to increase the size of the physical dimensions of interposers and other advanced packaging substrates. In some embodiments, customization to the HBM bottom die allows for more flexible communication and an increase in the content allowed on the interposer itself. Although rectangular die, bottom buffers and interposers are discussed and shown in the Figures, other shapes (e.g., square, pentagonal, hexagonal, circular, octagonal, diamond shaped, etc.) can be utilized.

In some embodiments, a configurable switch, cross-bar, or other connection matrix that contains high bandwidth ingress/egress signaling and that is route accessible on all four sides of the HBM device by adjacent die is included on the HBM bottom die. The configuration enables the addition of more chip content on the interposer and enables higher inter-die bandwidth in some embodiments. Each side of the die can represent a set of logical ports that provide connectivity to ports on any of the three alternate sides of the device or to the local HBM device itself. The ports are sub-divided by the number of HBM channels or into other groupings in some embodiments. In this way, access to the HBM can be provided to/from any of the interfaces in some embodiments. In some embodiments, the HBM can act as a forwarding switch to/from other general devices adjacent to the HBM for data that is unrelated to the local HBM storage. In some embodiments, the HBM is no longer a connectivity termination point, but a bridge to other functions in the SIP. A crossbar switch can refer to a circuit that facilitates interconnection within the IC dies (e.g., to ports) in some embodiments. The crossbar switch can act as traffic director, orchestrating the flow of signals and data between various functional blocks. In some embodiments, the cross bar switch includes a matrix of intersecting horizontal and vertical lines, forming a grid-like structure that enables multiple inputs to be selectively routed to specific outputs (e.g. via switches).

In some embodiments, the bottom buffer of the HDM is coupled to the interposer or package substrate by micro-bump bonding pads. In some embodiments, the interposer is coupled to the package substrate by micro-bump bonding pads. In some embodiments, a higher per pin speed interface is used to reduce the number of pins required per interface. This allows more efficient use of the fixed micro-bump resources in some embodiments.

Broadcom D2D interfaces or other D2D interfaces (e.g., Universal Chiplet Interconnect Express (UCIe^{™}), bunch of wires (BoW), etc.) can provide connections to the IC dies. Each D2D interface can be sub-divided into smaller lanes or channels in some embodiments. The interface can be configurable based on the application. For adjacent connections between die, only a subset of available lanes may be required depending on bandwidth needs in some embodiments. In some embodiments, unused lanes can be disabled for power savings as well as route savings on the interposer or package substrate. The ability to disable unused D2D signals on the HBM device has little cost to the system implementation, but allows for significant flexibility in connection of components based on required bandwidth in some embodiments. In some embodiments, the systems and methods provide flexible approach to allocation of D2D signaling ports for maximum flexibility in physical attachment between adjacent die.

In some embodiments, the systems and methods provide flexibility for extending the perimeter to meet the design criteria and requirements of the SIP high performance computing (HPC) and artificial intelligence (AI) applications. In some embodiments, the SIP includes one or more compute die and one or more HBM die. In some embodiments, the SIP includes one or more compute die, one or more I/O die and one or more HBM die. The one or more HBM die has high bandwidth connections to the one or more compute die as well as to the one or more I/O dies in some embodiments.

Some embodiments are related to an integrated circuit package. The integrated circuit package includes a first integrated circuit die, a second integrated circuit die, and a third integrated circuit die. The integrated circuit package also includes a support structure. The first integrated circuit die, the second integrated circuit die, and the third integrated circuit die are attached to the support structure. The first integrated circuit die includes a first interface on a first side of the first integrated circuit die and the second integrated circuit die includes a second interface on a second side of the second integrated circuit die. The first side neighbors the second side. The first integrated circuit die is configured to communicate with second integrated circuit die via the first interface and the second interface. The first integrated circuit die includes a third interface on a third side of the first integrated circuit die and the second integrated circuit die includes a fourth interface on a fourth side of the second integrated circuit die. The third die includes a fifth interface on a fifth side and a sixth interface on sixth side. The sixth side is parallel to the third side and the fifth side, The first integrated circuit die is configured to communicate with the third integrated circuit die via the fifth interface and the third interface. The second integrated circuit die is configured to communicate with the third integrated circuit die via the sixth interface and the fourth interface.

An interface refers to a boundary or point of interaction between two or more die, systems, devices, or components where communication, interaction, or exchange occurs in some embodiments. An interface can be an input/output interface. In various contexts, an interface serves as a means for different elements to connect and interact with each other. Integrated circuit die refers to chip, substrate or structure that contains an integrated circuit in some embodiments. An IC or integrated circuit refers to an electronic circuit that includes small components (e.g., transistors, diodes, resistors, capacitors, or inductors) that are fabricated on substrate in some embodiments. Neighbors or neighboring can refer to a side of a die being next to a side of another die in some embodiments. In some embodiments, neighboring sides of die can be parallel in some embodiments. A neighboring die can be a next die if there is not an intervening die. Neighboring does not necessarily imply a distance of separation between the neighboring die.

In some embodiments, the support structure includes an interposer. In some embodiments, the support structure includes a package substrate. In some embodiments, the first integrated circuit die and second integrated circuit die comprise a memory circuit. In some embodiments, the first integrated circuit die and second integrated circuit die include a high bandwidth memory. In some embodiments, the high bandwidth memory is a stack of IC die. An interposer refers to an interposer refers to any structure that facilitates connections between the die and the package substrate or any other die in some embodiments. An interpose can be an intermediary substrate layer placed between the integrated circuit (IC) and the package substrate. The interposer can enable finer pitch connections than would be possible directly between the IC and the package substrate. A memory circuit refers to any device capable of electronic storage of data ins some embodiments. A high bandwidth memory refers to a memory circuit that provides high bandwidth performance in some embodiments.

In some embodiments, the package also includes a fourth integrated circuit die. The fourth integrated circuit die includes a seventh interface on a seventh side, and wherein the first integrated circuit die includes an eighth interface on a sixth side. The first integrated circuit die is configured to communicate with the fourth integrated circuit die via the seven interface and the eight interface. The sixth side and seventh side are neighboring sides and the sixth side is opposite the first side. In some embodiments, the fourth integrated circuit die includes an input/output circuit. An Input/Output (I/O) circuit, an I/O interface or I/O controller refers to any component or subsystem that facilitates communication between a device and external peripherals or systems in some embodiments. The I/O circuit can manage the exchange of data, commands, and control signals in some embodiments.

In some embodiments, the fourth integrated circuit die includes a compute circuit. In some embodiments, first interface and the second interface is configurable. In some embodiments, interface is provided along at least 90 percent of the first side. In some embodiments, the first interface is larger than the third interface.

Some embodiments relate to a package. The package includes a first high bandwidth memory die including a first cross bar circuit on a first bottom level and a first die to die interface on a first side and a second die to die interface on a second side, a second high bandwidth memory die including a second cross bar circuit on a second bottom level and a third die to die interface on a third side and a fourth die to die interface on a fourth side, and a compute die. The compute die includes a fifth die to die interface on a fifth side and is in communication with the fourth die to die interface. The fifth side is parallel to the fourth side and the first die to die interface is in communication with the third die to die interface. The first side and the third side are parallel. A cross bar circuit refers to any circuit used to create a matrix of connections between multiple input and output lines in some embodiments. The crossbar circuit can facilitate non-blocking, point-to-point communication between different input and output lines for IC die.

In some embodiments, the fourth die to die interface is configurable (e.g., in size and shape). In some embodiments, the fourth die to die interface is configurable in size. In some embodiments, the first die to die interface is the same size as the second die to die interface. In some embodiments, the package also includes an input/output die. In some embodiments, the input/output die comprises a serializer deserializer circuit. In some embodiments, the input/output die comprises a memory interface circuit. A serializer deserializer circuit refers to any circuit used to convert parallel data streams into serial data streams (serialization) and vice versa (deserialization) in some embodiments. A memory interface circuit refers to any circuit that facilitates communication with a memory circuit in some embodiments. The memory interface circuit can manage the exchange of data, addresses, and control signals between the CPU or memory controller and the memory modules in some embodiments.

Some embodiments relate to a method. The method includes providing a first integrated circuit die on an interposer or a package substrate. The method also includes providing a second integrated circuit die on the interposer or the package substrate. The method also includes providing a third integrated circuit die on the interposer or the package substrate. The first integrated circuit die includes a first interface on a first side of the first integrated circuit die and the second integrated circuit die includes a second interface on a second side of the second integrated circuit die. The first side neighbors the second side. The first integrated circuit die is configured to communicate with the second integrated circuit die via the first interface and the second interface. The first integrated circuit die includes a third interface on a third side of the first integrated circuit die and the second integrated circuit die includes a fourth interface on a fourth side of the second integrated circuit die. The third die includes a fifth interface on a fifth side and a sixth interface on sixth side. The sixth side is parallel to the third side and the fifth side. The first integrated circuit die is configured to communicate with the third integrated circuit die via the fifth interface and the third interface. The second integrated circuit die is configured to communicate with the third integrated circuit die via the sixth interface and the fourth interface.

In some embodiments, the first interface is configurable and uses through vias coupled to the interposer or the package substrate. According to a first exemplary aspect, a SIP includes (a) a substrate having a substrate body and a main surface; (b) an array of solder connection elements formed at the main surface; and (c) an interposer at the main surface. In some embodiments, a Ball Grid Array (BGA) is provided on the substrate. The SIP may be at least a part of a Surface Mount Device (SMD), i.e. a packaged electronic component being configured for being surface mounted. The surface mounting may be carried out for instance with placement machines of any type (e.g., pick and place placement machines).

In some embodiments, the solder connection elements are solder balls or micro balls. However, other geometries deviating from a ball shape may be used for realizing the solder connection element(s). Other possible geometries may include ellipsoid, conical, cylindrical, cuboid geometries or combinations thereof.

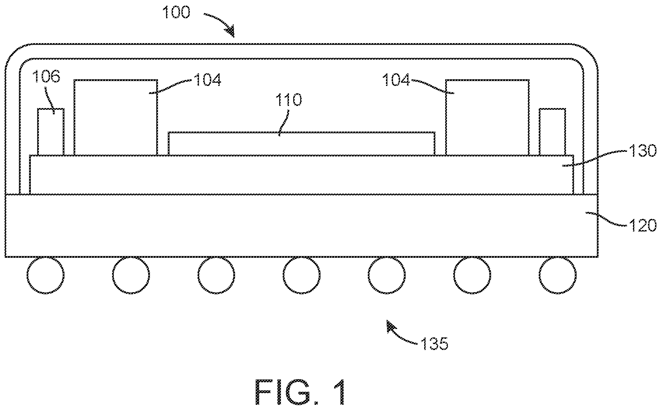

FIG. 1 shows an electronic package 100 according to some embodiments. The electronic package 100 includes die 104, 106, and 110, a package substrate 120, and an interposer 130. Electronic package 100 can be an IC package containing a SIP for HPC and AI operations in some embodiments.

In some embodiments, die 104, 106, and 1110 are coupled directly to package substrate 120. In some embodiments, die 104 includes circuitry for an HBM and die 106 includes circuitry for input/output (I/O) operations. Die 104 can be a stack of layers or die. Die 104 can include a cross bar switch. Die 106 includes a serializer/ deserializer (SERDES) circuitry in some embodiments. In some embodiments, die 110 is a computational die. The sizes, dimensions and number of dies shown in FIG. 1 are exemplary.

Interposer 130 is connected by solder connection elements (e.g., micro bumps) to each of die 104, 106 and 110. The package substrate 120 is coupled interposer 130 by micro bumps in some embodiments. Other types of connections can be utilized for connecting die 104, 106, 110, interposer 130 and package substrate 120. The solder connection elements can be or include solder balls, pins, wires or other conductive elements. Package substrate 120 can include a number of solder connection elements 130 formed on the lower main surface. Interposer 130, package substrate 120, or the combination of interposer 130 and package substrate 120 can be a support structure or base for package 100 in some embodiments.

Depending on the specific application, the substrate 120 may be any suitable support (basis) for die 104, 106, and 110, which allows electrical chip connections with at least one solder connection element 135. The substrate 120 and interposer 130 may include embedded electric circuitry within a substrate 120 or interposer 130. The embedded electric circuitry forms a redistribution structure in some embodiments. The electric circuitry may include conductor paths that are parallel to a main surface (horizontal) and conductor paths that are perpendicular to the main surface (vertical) (e.g., via connections). The redistribution structure may allow the solder connection elements with regard to the chip connections to be spatially spread. The substrate 120 and interposer 130 may be made of or may include for instance a Printed Circuit Board (PCB) (e.g., a multilayer PCB made from either organic or ceramic materials).

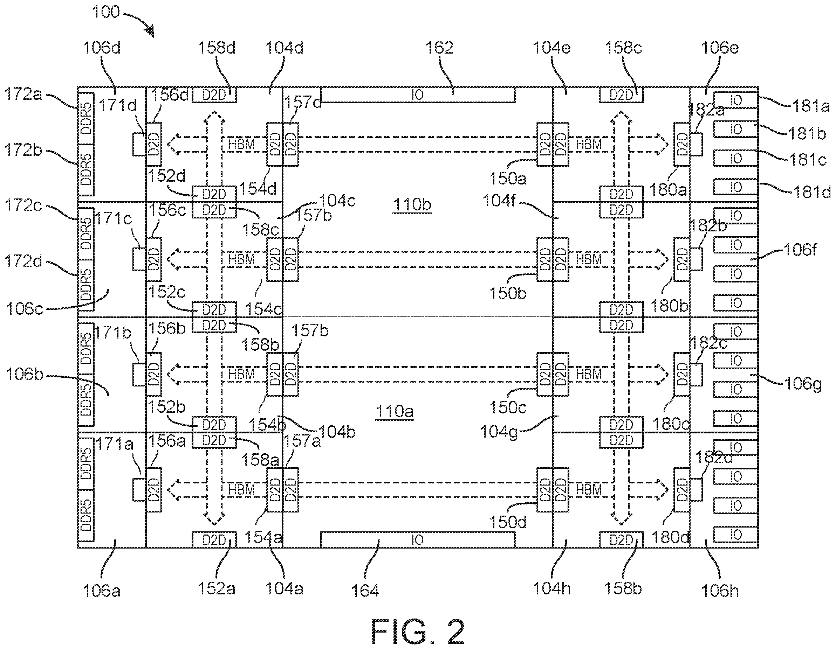

With reference to FIG. 2, electronic package 100 includes die 110a and 110b configured as computing circuits, die 104a-h configured as memory circuits (e.g., HBM)s, and die 106 a-h in some embodiments. Die 106 a-d are configured as I/O circuitry in some embodiments. Die 106a-d can include a circuit for a memory interface. The memory interface circuit can be a DDR5, or Double Data Rate 5, or DDR 4 interface circuit in some embodiments. The interface circuit can include on-die ECC (Error-Correcting Code) functionality, which helps improve the reliability of data stored in memory by detecting and correcting errors. In some embodiments, die 106a-h provide a low voltage interface. Die 106e-h can be configured as a SERDES circuit. One of die 110 a-b, two of die 106 a-h, and two of die 104a-h correspond to die 110, 106, and die 104, respectively, in FIG.1 according to some embodiments.

Die 106c-d communicate with interposer 130 or package substrate 120 via interfaces 172a-d at a periphery of die 106c-d. Interfaces 172a-d are DDR5 interfaces and are located on an outside periphery of die c-d in some embodiments. IC die 106a-b and have similar interfaces. Die 106a-d communicate with die104a-d via interfaces 171a-d and interfaces 156a-d. Interfaces 171a-d and interfaces 156a-d are d2d interfaces in some embodiments.

Interfaces 156a-d and 171a-d communicate through circuit paths or routes associated with interposer 130 in some embodiments. Die 104a-d include interfaces 152a-d and 158a-d which provide connections between neighboring die 104a-d. Interfaces 152a-d and 158a-d are similar to interfaces 156a-d and are d2d interfaces in some embodiments. Interface 152a and 156d do not have a matching interface and can be used for connections off of package 100 or to other die 106a-h, 110a-b and 106a-h. Die 104a-d communicate with die 110a-b using interfaces 154a-d via interfaces 157a-d of die 110-b. Interfaces 154a-d and 161a-d are similar to interfaces 172a-d, 152a-d, 156a-d, and 158a-d. Die 110a-b can communicate with each other through interfaces 152a-d, 154a-d and 158a-d of die 104a-h and with die 106a-h interfaces 152a-d, 154a-d, 156a-d and 158a-d of die 104a-h.

Die 1 10a-b include interfaces 162 and 164 that can be used for connections off package or to other die 106a-h, 110a-b and 106a-h . Interfaces 162 and 164 are d2d interfaces in some embodiments. Interfaces 157a-d and 154a-d can have a same size. Interfaces 162 and 164 are larger than interfaces 157a-d in some embodiments. Interfaces 152a-d and 158a-d can have the same size in some embodiments.

Die 104e-h include interfaces similar to interfaces 158a-d, 152a-d, 154a-d and 154a-d in some embodiments. Die 106 e include interfaces 181a-d which are I/O interfaces in some embodiments. Die 106f-g can include similar interfaces. Die 104e-h include interfaces 180a-d for communication with interfaces 182a-d of die 106e-h. Interfaces 180a-e and 182a-d are similar to interfaces 152a-d and 171a-d in some embodiments. Interfaces 182a-d and 171a-d are smaller than interfaces 156a-d and 180a-d in some embodiments. The difference in size can be used to accommodate different configurations. In some embodiments, interfaces are not provided between die 110a and 110b. The lack of interfaces at a junction between die 110a-b allows more area for computing functionality. Die 106a-h advantageously have interfaces on four sides, thereby allowing greater expansion.

The D2D interface refers to a communication mechanism that allows die to directly exchange data with each other without the need for an off package connection in some embodiments. The D2D interface allows the communication and interaction between different integrated circuit (IC) dies within a multi-chip module (MCM) or a system-in-package (SiP). The D2D interface facilitates communication and data exchange between die, enabling the die to work together seamlessly in some embodiments. The D2D interface can have advantages of high-speed data transfer, low-latency communication, and efficient power management. The D2D interface can use various communication protocols to ensure that the different IC dies can understand and exchange data with each other. Example protocols include high-speed serial interfaces like PCIe (Peripheral Component Interconnect Express) or parallel interfaces. The physical connection of the D2D interfaces can include a combination of micro bumps, through-silicon vias (TSVs), or other advanced packaging connection techniques. The D2D interface can include a clocking mechanism involving a shared clock signal or sophisticated clock distribution systems to maintain coherence and prevent timing issues. The D2D interface can include error detection and correction mechanisms to ensure data integrity. Techniques like parity checking or more advanced error correction codes may be employed to identify and rectify any errors that may occur during data transmission.

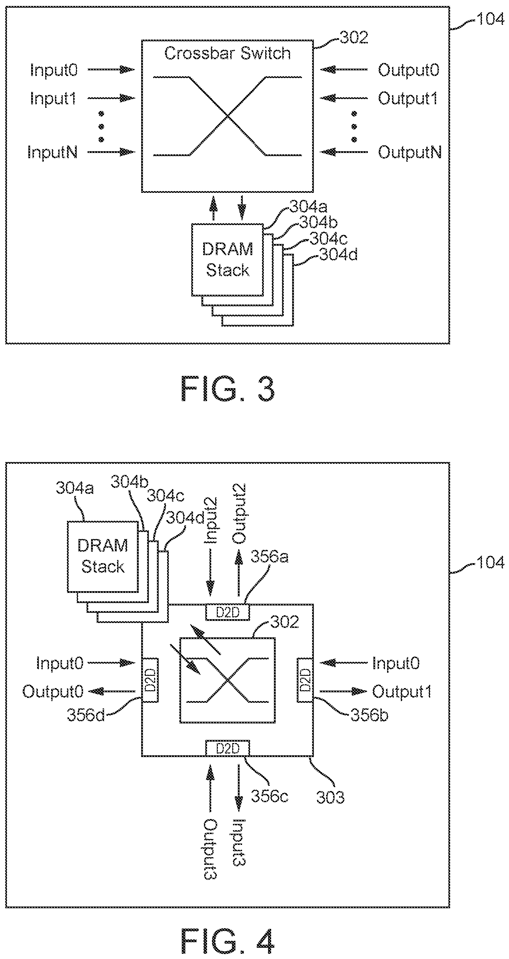

With reference to FIGS. 2 and 3, die 104 which can be any of die 104a-h includes a cross bar switch circuit 302. The cross bar switch can be programmed for particular configurations of die 110a-b, 104a-h and 106a-h and associated interfaces. In some embodiments, the cross bar switch circuit 102 is provided on a base or bottom die or layer of die 104. Die 104 is comprised of a stack of die 304a-d (e.g., HBM die) provided above a base associated with cross bar switch circuit 102 in some embodiments. In some embodiments, cross bar switch circuit 102 is included on die 106a-h and 110a-b. With reference to FIGS. 2, 3 and 4, cross bar switch circuit 302 is provided on a base layer or bottom die 303. Die 303 also includes interfaces 356a-d. Interfaces 356a-d can be interfaces 352a-d, 354a-d, 356a-d, and 358a-d in some embodiments.

The use of D2D interfaces allows a much higher bandwidth per millimeter (BW/mm) when compared to a JEDEC HBM I/O standard (e.g., a 4x-8x higher data rates reduces signal bump count accordingly). In some embodiments, dies 104a-h include an HBM4 controller on its base or bottom die along with the cross bar switch circuit 302. Advantageously, package 100 allows the use of larger interposers 130 and/or glass substrates as die 104a-h are accessible from all sides and are no longer bookended.

In some embodiments die 104 is any type of computer memory architecture. Die 104 can be configured for faster communication between die 104 and die 110. Die 104 can include stacked multiple layers of DRAM (Dynamic Random Access Memory) die 304a-d vertically on top of each other, forming a 3D structure. The vertically stacked layers of die 304a-d reduce the physical footprint of the memory and enable extremely fast data access, resulting in improved performance for graphics-intensive applications, artificial intelligence, and other memory-intensive tasks in some embodiments.

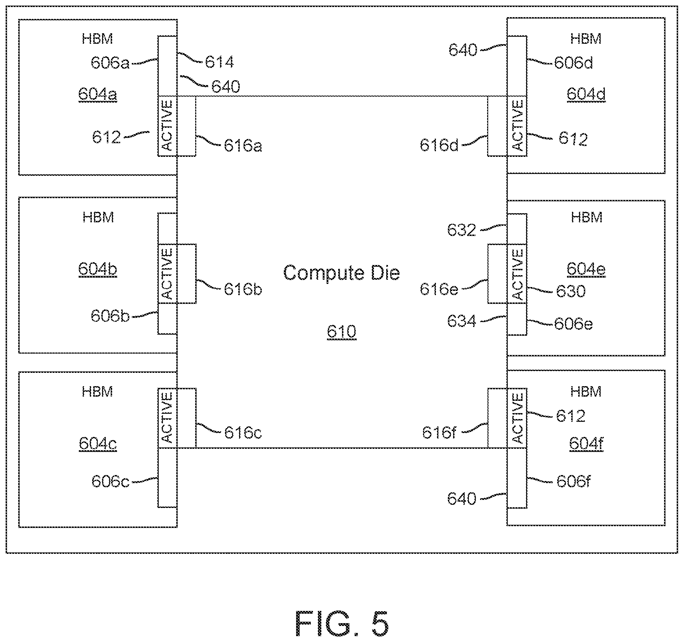

With reference to FIG. 5, an electronic package 600 is similar to package 100. Package 600 includes die 610 configured as a computing circuit and die 604a-f configured as a a memory circuit (e.g., an HBMs). Die 604a-f communicate with interfaces 616a-f of die 610 via interfaces 606a-f, respectively, of die 604a-f. Interfaces 606a-f are d2d interfaces that are larger than interfaces 616a-f. Interfaces 606a-f each include an inactive portion 614 and an active portion 612 in some embodiments. Active portion 612 matches to interfaces 616a-f so that the position and size of active portion 612 and inactive portion 614 in some embodiments. In some embodiments, active portion 612 can be selected to provide the best or near best physical arrangement based on the die-to-die perimeter abutment.

In some embodiments, interfaces 606a-f are on die 610 and interfaces 616a-f are on die 604a-f. In some embodiments, interfaces 616a-f are configurable. Interfaces 606a-f can have active portion 612 in a middle 630 of inactive portion 614 (e.g., areas 632 and 634) or be on an end leaving an inactive portion on the other end 640. Inactive portion 614 can be disabled for power savings in some embodiments.

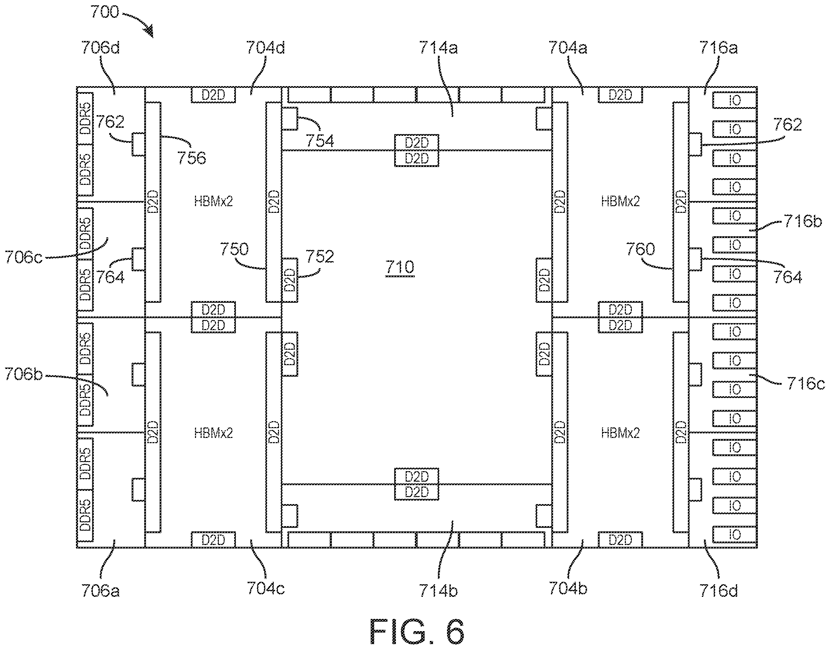

With reference to FIG. 6, an electronic package 700 is similar to package 100. Package 700 includes die 710 configured as a computing circuit, die 706a-d configured as I/O circuits, die 716a-d configured as I/O circuits, die 714a-b configured as I/O circuits, and die 704a-h configured as memory circuits (e.g., an HBMs). Die 716a-d can include a circuit for a memory interface similar to die 106a-d, and die 716a-d can include a circuit for an I/O interface and can be similar to die 106 a-h (FIG.2). Die 714a-b can be similar to die 716a-h in some embodiments.

Die 704a is in communication with die 716a-b via interfaces 762 and 764 and interface 760. Interface 760 extends along the periphery of a side of die 104a (e.g., almost along the entire side or over 90 percent) in some embodiments. Unused portions or lanes of interface 760 can be disabled for power savings in some embodiments. Die 704d is in communication with die 706a-b via interfaces 758 and 760 and interface 756. Interface 756 extends along the periphery of a side of die 104d (e.g., almost along the entire side or over 90 percent) in some embodiments. Unused portions or lanes of interface 756 can be disabled for power savings in some embodiments.

Die 704d includes an interface 750 along on opposite side to the side of interface 756. Die 704d is in communication with die 710 and die 714a via interfaces 754 and 752 and interface 750. Interface 750 extends along the periphery of a side of die 104a (e.g., almost along the entire side or over 90 percent) in some embodiments. Unused portions or lanes of interface 750 can be disabled for power savings in some embodiments. Die 704c-b can include similar interfaces to die 704a-b. Die 710 can communicate with die 716a-d and 704a-d in similar fashion as described above. The above described interfaces can be customized for bandwidth depending on system parameters and design criteria.

It should be noted that the term "comprising" does not exclude other elements or operations and the use of articles "a" or "an" does not exclude a plurality. Also elements described in association with different embodiments may be combined. It should also be noted that reference signs in the claims should not be construed as limiting the scope of the claims.

## Claims

1. An integrated circuit package (100), comprising
a first integrated circuit die (104);
a second integrated circuit die (106);
a third integrated circuit die (110); and
a support structure (120, 130), wherein the first integrated circuit die (104), the second integrated circuit die (106), and the third integrated circuit die (110) are attached to the support structure (120, 130), wherein the first integrated circuit die (104) comprises a first interface on a first side of the first integrated circuit die (104) and the second integrated circuit die (106) comprises a second interface on a second side of the second integrated circuit die (106), wherein the first side neighbors the second side, wherein the first integrated circuit die (104) is configured to communicate with the second integrated circuit die (106) via the first interface and the second interface, wherein the first integrated circuit die (104) comprises a third interface on a third side of the first integrated circuit die (104) and the second integrated circuit die (106) comprises a fourth interface on a fourth side of the second integrated circuit die (106), wherein the third integrated circuit die (110) comprises a fifth interface on a fifth side and a sixth interface on sixth side, the sixth side being parallel to the third side and the fifth side, wherein the first integrated circuit die (104) is configured to communicate with the third integrated circuit die (110) via the fifth interface and the third interface, wherein the second integrated circuit die (106) is configured to communicate with the third integrated circuit die (110) via the sixth interface and the fourth interface.

2. The integrated circuit package (100) as set forth claim 1, wherein the support structure (120, 130) comprises an interposer (130).

3. The integrated circuit package (100) as set forth in claim 2, wherein the support structure (120, 130) comprises a package substrate (120).

4. The integrated circuit package (100) as set forth in any of claims 1 to 3, wherein the first integrated circuit die (104) and the second integrated circuit die (106) comprise a memory circuit.

5. The integrated circuit package (100) as set forth in any of claims 1 to 4, wherein the first integrated circuit die (104) and the second integrated circuit die (106) comprise a high bandwidth memory.

6. The integrated circuit package (100) as set forth in any of claims 1 to 5, comprising a fourth integrated circuit die, wherein the fourth integrated circuit die includes a seventh interface on a seventh side, and wherein the first integrated circuit die (104) comprises an eighth interface an sixth side, wherein the first integrated circuit die (104) is configured to communicate with the fourth integrated circuit die via the seventh interface and the eighth interface, wherein the sixth side and seventh side are neighboring sides and the sixth side is opposite the first side.

7. The integrated circuit package (100) as set forth in claim 6, wherein the fourth integrated circuit die comprises an input/output circuit.

8. The integrated circuit package (100) as set forth in claim 6 or 7, wherein the fourth integrated circuit die comprises a compute circuit.

9. The integrated circuit package (100) as set forth in any of claims 1 to 8, comprising at least one of the following features:
wherein the first interface and the second interface is configurable;
wherein the first interface is provided along at least 90 percent of the first side;
wherein the first interface is larger than the third interface.

10. A package (100), comprising:
a first high bandwidth memory die comprising a first cross bar circuit on a first bottom level and a first die to die interface on a first side and a second die to die interface on a second side;
a second high bandwidth memory die comprising a second cross bar circuit on a second bottom level and a third die to die interface on a third side and a fourth die to die interface on a fourth side; and
a compute die comprising a fifth die to die interface on a fifth side and in communication with the fourth die to die interface, the fifth side is parallel to the fourth side and the first die to die interface is in communication with the third die to die interface, wherein the first side and the third side are parallel.

11. The package (100) as set forth in claim 10, comprising at least one of the following features:
wherein the fourth die to die interface is configurable;
wherein the fourth die to die interface is configurable in size;
wherein the first die to die interface is the same size as the second die to die interface.

12. The package (100) as set forth in any of claims 10 or 11, further comprising an input/output die.

13. The package (100) as set forth in claim 12, comprising at least one of the following features:
wherein the input/output die comprises a serializer deserializer circuit;
wherein the input/output die comprises a memory interface circuit.

14. A method, comprising:
providing a first integrated circuit die (104) on an interposer (130) or a package substrate (120);
providing a second integrated circuit die (106) on the interposer (130) or the package substrate (120);
providing a third integrated circuit die (110) on the interposer (130) or the package substrate (120); and
wherein the first integrated circuit die (104) comprises a first interface on a first side of the first integrated circuit die (104) and the second integrated circuit die (106) comprises a second interface on a second side of the second integrated circuit die (106), wherein the first side neighbors the second side, wherein the first integrated circuit die (104) is configured to communicate with the second integrated circuit die (106) via the first interface and the second interface, wherein the first integrated circuit die (104) comprises a third interface on a third side of the first integrated circuit die (104) and the second integrated circuit die (106) comprises a fourth interface on a fourth side of the second integrated circuit die (106), wherein the third integrated circuit die (110) comprises a fifth interface on a fifth side and a sixth interface on sixth side, the sixth side being parallel to the third side and the fifth side, wherein the first integrated circuit die (104) is configured to communicate with the third integrated circuit die (110) via the fifth interface and the third interface, wherein the second integrated circuit die (106) is configured to communicate with the third integrated circuit die (110) via the sixth interface and the fourth interface.

15. The method of claim 14, wherein the first interface is configurable and uses through vias coupled to the interposer (130) or the package substrate (120).
